(19) Europäisches Patentamt
European Patent Office
Office européen des brevets

(11) **EP 3 778 724 B1**

(12) **EUROPEAN PATENT SPECIFICATION**

(45) Date of publication and mention
of the grant of the patent:
**01.05.2024  Bulletin 2024/18**

(21) Application number: **19775572.1**

(22) Date of filing: **27.03.2019**

(51) International Patent Classification (IPC):
*C08J 5/00* (2006.01)       *C08J 5/18* (2006.01)
*C08L 27/16* (2006.01)      *C08L 27/18* (2006.01)
*B29C 43/58* (2006.01)      *B29C 48/00* (2019.01)
*B29C 55/18* (2006.01)      *B29K 27/00* (2006.01)
*B29K 27/18* (2006.01)      *B29K 105/16* (2006.01)
*B29K 105/18* (2006.01)     *B82Y 15/00* (2011.01)
*B29C 48/08* (2019.01)      *B82Y 40/00* (2011.01)
*C08F 214/22* (2006.01)     *C08F 214/26* (2006.01)

(52) Cooperative Patent Classification (CPC):
(C-Sets available)
**B29C 48/08; B29C 43/58; B29C 48/0018;
B29C 55/18; C08F 214/22; C08F 214/26;
C08J 5/18;** B29C 48/305; B29C 48/914;
B29C 2043/5833; B29K 2027/16; B29K 2027/18;
B29K 2105/162; B29K 2105/18; B29K 2995/0003;

*(Cont.)*

(86) International application number:
**PCT/JP2019/013109**

(87) International publication number:
**WO 2019/189319 (03.10.2019 Gazette 2019/40)**

(54) **MOLDED ARTICLE**

FORMKÖRPER

ARTICLE MOULÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.03.2018   JP 2018069704**

(43) Date of publication of application:
**17.02.2021   Bulletin 2021/07**

(73) Proprietors:
• Hiroshima University
**Higashihiroshima-shi
Hiroshima 739-8511 (JP)**
• DAIKIN INDUSTRIES, LTD.
**Osaka-Shi, Osaka 530-0001 (JP)**

(72) Inventors:
• **HIKOSAKA, Masamichi
Higashihiroshima-shi, Hiroshima 739-2106 (JP)**
• **OKADA, Kiyoka
Higashihiroshima-shi, Hiroshima 739-8521 (JP)**
• **FUKUSHIMA, Toshiyuki
Osaka-Shi, Osaka 530-8323 (JP)**
• **SAWAKI, Kyouhei
Osaka-Shi, Osaka 530-8323 (JP)**
• **OKANISHI, Ken
Osaka-Shi, Osaka 530-8323 (JP)**
• **YAMAGUCHI, Yasuyuki
Osaka-Shi, Osaka 530-8323 (JP)**

(74) Representative: **Hoffmann Eitle
Patent- und Rechtsanwälte PartmbB
Arabellastraße 30
81925 München (DE)**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

(56) References cited:
EP-A1- 2 910 604          WO-A1-2008/090947
WO-A1-2012/108463       WO-A1-2014/158956
WO-A2-2010/008450       JP-A- 2012 149 152
JP-A- 2014 156 581        US-A1- 2004 131 862

- CARR JOEL M ET AL: "Structure and transport properties of polyethylene terephthalate and poly(vinylidene fluoride-co-tetrafluoroethylene) multilayer films", POLYMER, ELSEVIER, AMSTERDAM, NL, vol. 54, no. 6, 31 January 2013 (2013-01-31), pages 1679-1690, XP028984179, ISSN: 0032-3861, DOI: 10.1016/J.POLYMER.2013.01.037
- MASAMICHI HIKOSAKA ET AL: "1G11: High heat resistance and high strength of nano-oriented crystals (NOC) discovered by strain-induced crystallization of Polymer", POLYMER PREPRINTS, JAPAN, vol. 64, no. 2, 25 August 2015 (2015-08-25), pages 1-2, XP009523740,
- HIKOSAKA, MASAMICHI et al.: "High heat resistance and high strength of nano-oriented crystals (NOC) discovered by strain-induced crystallization of Polyme r", Polymer Preprints, vol. 64, no. 2, 25 August 2015 (2015-08-25), XP009523740, Japan
- OKADA, KIYOKA et al.: "The universality of nano-oriented crystal formation in strain-induced crystallization and verification of nucleation rate-limiting", Polymer Preprints, vol. 63, no. 1 , XP009523881,
- FUKUSHIMA, TOSHIYUKI et al.: "Undercooling dependence of nucleation rate of vinylidene fluoride/tetrafluoroethylene copolymer (P(VDF/TFE", Polymer Preprints, vol. 66, no. 1, 15 May 2017 (2017-05-15), XP009523739,

(52) Cooperative Patent Classification (CPC): (Cont.)
B29K 2995/0016; B29K 2995/0041;
B29K 2995/005; B29K 2995/0072;
B29K 2995/0077; B82Y 15/00; B82Y 40/00;
C08J 2327/16; C08J 2427/18

C-Sets
C08F 214/22, C08F 214/26;
C08F 214/26, C08F 214/22

**Description**

TECHNICAL FIELD

The invention relates to molded articles having excellent mechanical strength, heat resistance, surface roughness, and ferroelectricity.

BACKGROUND ART

A variety of organic dielectric films and inorganic dielectric films are conventionally known as films to be used for piezoelectric films that serve as ferroelectric materials and for electrowetting applications or film capacitor applications. Films of a vinylidene fluoride (VdF)/tetrafluoroethylene (TFE) copolymer or a vinylidene fluoride (VdF) polymer among these advantageously have transparency and, unlike inorganic dielectric thin films, flexibility, so that such films can be used in a variety of applications.

For a ferroelectric film of a VdF polymer, which is a typical example of ferroelectric polymer films, conventional production thereof includes melt crystallization that causes generation of α crystals after film formation. Thus, to form β crystals that exhibit ferroelectricity, the resulting film needs to undergo complicated steps of stretching, heat setting, and poling the film.

For a conventional ferroelectric film of a VdF/TFE copolymer, melt crystallization with ≥ 7 mol% of a TFE unit can lead to a film in which β crystals are directly formed. Thus, poling the resulting film can provide the target ferroelectric film. Still, to achieve high ferroelectricity, the molecular chain needs to be oriented by complicated steps of stretching and heat setting (J.C. Hicks et al., J. Appl. Phys., 49, 6092 (1978)).

A conventionally known method for improving the ferroelectricity of a VdF/TFE copolymer is a method for producing a highly crystallized film including melt crystallization at high temperature and high pressure. Still, the resulting film is disadvantageously cloudy and brittle (S. Tasaka et al., J. Appl. Phys., 57(3), 906 (1985)).

Production of films by stretching unfortunately includes complicated production steps and the resulting films are insufficient for some applications in terms of properties such as mechanical strength and heat resistance. Thus, films need to be further improved so as to meet current high-level requirements.

For commodity plastics such as polypropylene and polyester, the presence of nano-oriented crystals (NOCs) is known to improve the properties, such as heat resistance, of films (JP-B-5487964 and WO 2016/035598). For fluororesins, the presence of NOCs is known to improve the heat resistance of polyvinylidene fluoride (PVdF) and a VdF/trifluoroethylene (TrFE) copolymer (M. Hikosaka et al., Polymer Preprints, Japan, 64(2), 1G11 (2015)).

US-A-2004/131862 discloses a process of forming a ferroelectric polymer film comprising disposing a solution comprising a ferroelectric polymer film precursor composition and a solvent composition onto a substrate, wherein the solvent composition has a $\delta_v$ value of ≥ 8.5, wherein $\delta_v = (\delta_d{}^2 + \delta_p{}^2)^{1/2}$, $\delta_d$ being a Hansen dispersive solubility parameter and $\delta_p$ being a Hansen polar solubility parameter; and removing at least a portion of the solvent to produce a ferroelectric polymer film.

WO 2014/158956 describes a ferroelectric material (12) comprising a polymer blend comprising a ferroelectric polymer (12a) and a dielectric polymer (12b) having a low dielectric constant, wherein the dielectric polymer (12b) can phase separate from the ferroelectric polymer (12a) such that a plurality of separated regions (12b) are formed within the ferroelectric polymer (12a). The ferroelectric material (12) is disposed between two electrodes (11) and (13), and the regions (12b) act as charge-trap regions to store charge and prevent charge carriers to move freely throughout the ferroelectric polymer (12a).

J.M. Carr et al., Polymer, 54(6), 1679-1690 (2013) reports on an investigation of structure and transport properties of PET and VdF/TFE copolymer multilayer films, and especially assesses the influence of crystal orientation in the films on the observed properties.

EP-A-2 910 604 relates to a high dielectric film having a thickness of 0.01-50 μm and comprising a VdF/TFE copolymer (A) having a VdF/TFE mole ratio of (95/5)-(80/20) and inorganic oxide particles (B), which film includes a β-crystal structure and optionally an α-crystal structure, with the ratio of the β-crystal structure being ≥ 50%.

SUMMARY OF INVENTION

- Technical Problem

The invention aims to provide a molded article having excellent mechanical strength, heat resistance, surface roughness, and ferroelectricity.

- Solution to Problem

The inventors have diligently studied for solutions of the above problems and, as a result, succeeded for the first time in obtaining a molded article containing very small crystals of a VdF/TFE copolymer by crystalizing a melt of the VdF/TFE copolymer while elongating the melt at a rate not lower than the "critical elongational strain rate". The inventors then found that the resulting molded article has excellent mechanical strength expressed by the elastic modulus and has excellent heat resistance, surface roughness, and ferroelectricity, completing the invention.

Thus, the invention provides a molded article which

(i) has an arithmetic average roughness of $\leq 3.0\ \mu m$, measured using a portable surface roughness tester (SJ-210 of Mitsutoyo Corp.) in conformity with ISO 1997, and
(ii) is made from a vinylidene fluoride (VdF)/tetrafluoroethylene (TFE) copolymer which

- contains $\geq 90$ mol% of units derived from VdF or TFE, based on all polymerized units of the copolymer,
- contains 50-95 mol% of VdF units and 5-50 mol% of TFE units, based on the total of VdF unit and TFE units in the copolymer, and
- comprises, in an amount of $\geq 60\%$ based on the VdF/TFE copolymer, crystals of the VdF/TFE copolymer, which are nano-oriented $\beta$ crystals having a size of $\leq 100$ nm, determined by the method defined later herein.

Preferred embodiments of the invention are as defined in the appended dependent claims and/or in the following detailed description.

- Advantageous Effects of Invention

The molded article of the invention (the present molded article) having the above structure can have excellent mechanical strength, heat resistance, surface roughness, and ferroelectricity.

BRIEF DESCRIPTION OF THE DRAWINGS

Fig. 1 is a schematic view of a structure of nano-oriented crystals (NOCs).
Fig. 2 is a schematic view of a rolling elongation crystallization device used for production of samples in examples.
Fig. 3 includes polarization microscopic images (results of observation in the through direction) of a sample in an example.
Fig. 4 includes small-angle X-ray scattering images of a sample in an example; Fig. 4(a) shows the result of observation in the through direction; Fig. 4(b) shows the result of observation in the edge direction; and Fig. 4(c) shows the result of observation in the end direction.
Fig. 5 includes wide-angle X-ray scattering images of a sample in an example; Fig. 5(a) shows the result of observation in the through direction; Fig. 5(b) shows the result of observation in the edge direction; and Fig. 5(c) shows the result of observation in the end direction.
Fig. 6 is a typical diagram of the results of measuring the tensile stress at break ($\sigma_B$) and the tensile modulus ($E_t$) of a sample in an example.
Fig. 7 is a diagram of the results of measuring the tensile stress at break ($\sigma_B$) and the tensile modulus ($E_t$) of a sample in a comparative example.
Fig. 8 is a typical diagram of the results of measuring the remanent polarization ($P_r$) and the coercive field ($E_c$) of a sample in an example.
Fig. 9 is a diagram of the results of measuring the remanent polarization ($P_r$) and the coercive field ($E_c$) of a sample of a comparative example.
Fig. 10 is a diagram of the results of measuring the tensile stress at break ($\sigma_B$) and the tensile modulus ($E_t$) of a sample of a comparative example.
Fig. 11 is a plot of the results of measuring the heatproof temperature of a sample in an example.
Fig. 12 is a plot of the results of measuring the heatproof temperature of a sample in a comparative example.

DESCRIPTION OF EMBODIMENTS

The following description will discuss details of the invention.
The present molded article contains a crystal of a VdF/TFE copolymer having a crystal size of 100 nm or smaller.

The VdF/TFE copolymer is a copolymer containing a polymerized unit based on VdF (hereinafter, also referred to as a "VdF unit") and a polymerized unit based on TFE (hereinafter, also referred to as a "TFE unit").

To provide a molded article having excellent mechanical strength, heat resistance, surface roughness, and ferroelectricity, the VdF/TFE copolymer contains 50-95 mol% of VdF units and 5-50 mol% of TFE units relative to 100 mol% in total of VdF units and TFE units. Preferably, the VdF units represent 60-95 mol% and the TFE units represent 5-40 mol%, more preferably, the VdF units represent 70-90 mol% and the TFE units represent 10-30 mol%.

The VdF/TFE copolymer may consist only of VdF units and TFE units, or may contain polymerized units based on a monomer copolymerizable with VdF and TFE and other than VdF and TFE. The VdF/TFE copolymer contains VdF units and TFE units in a total amount of $\geq 90$ mol%, preferably $\geq 95$ mol%, more preferably 98 mol%, of all polymerized units.

Examples of the monomer copolymerizable with VdF and TFE include hexafluoropropylene (HFP), ethylene, propylene, alkyl vinyl ether, vinyl acetate, vinyl chloride, vinylidene chloride, $CH_2=CHCF_3$, $CH_2=CFCF_3$, $CH_2=CF(CF_2)_nH$ (n = 3-7), and $CH_2=CH(CF_2)_nF$ (n = 1-8).

Preferred among these is at least one of HFP and $CH_2=CFCF_3$, more preferred is HFP.

To provide a molded article having excellent mechanical strength, heat resistance, surface roughness, and ferroelectricity, the polymerized units based on a monomer copolymerizable with VdF and TFE is in an amount of 0-10 mol%, preferably 0.01-5 mol%, more preferably 0.1-2 mol%.

The VdF/TFE copolymer used in the invention preferably has a weight average molecular weight of $\geq 10,000$, more preferably $\geq 50,000$, while preferably $\leq 400,000$, more preferably $\leq 300,000$.

The weight average molecular weight is a value determined by gel permeation chromatography (GPC).

The VdF/TFE copolymer can be crystallized into a hexagonal crystal form (morphology) (A.J. Lovinger et al., Macromolecules, 19, 1491 (1986)) and thus is likely to show polymer chain sliding diffusion (M. Hikosaka, Polymer, 28, 1257 (1987)), so that the critical elongational strain rate thereof for formation of nano-oriented crystals is presumed to be lower (K. Okada et al., Polymer Preprints, Japan, 63(1), 1331 (2014)). Accordingly, as described later, the VdF/TFE copolymer can easily form NOCs and is industrially advantageous.

The VdF/TFE copolymer is obtainable by e.g. a conventionally known solution polymerization, suspension polymerization (dispersion polymerization) or emulsion polymerization. A polymerization initiator to be used can be selected as appropriate from those conventionally used in accordance with the polymerization technique used.

Examples of the polymerization initiator include organic peroxides such as bis(chlorofluoroacyl)peroxide, bis(perfluoroacyl)peroxide, bis(w-hydroperfluoroacyl)peroxide, t-butyl peroxyisobutyrate, and diisopropyl peroxydicarbonate; and azo compounds such as azobisisobutyronitrile. The polymerization initiator may be used in an amount that can be changed as appropriate in accordance with factors such as the type of the initiator and the polymerization reaction conditions. The amount thereof is usually 0.005-5 wt.%, particularly 0.05-0.5 wt.%, relative to all monomers to be polymerized.

Polymerization reaction conditions used may be wide range reaction conditions without limitation. For example, an optimal polymerization reaction temperature may be selected in accordance with the type of a polymerization initiator. The polymerization reaction temperature used may be usually 0-100°C, particularly 30-90°C. The reaction pressure may also be selected as appropriate, and is usually 0.1-5 MPa, particularly 0.5-3 MPa. Polymerization for the VdF copolymer used in the invention can be advantageously performed at the above reaction pressure. Still, the polymerization may be performed at a higher pressure or under a reduced pressure condition. The polymerization type used may be either a batch type or continuous type, for example.

To adjust the molecular weight of the VdF/TFE copolymer, a chain transfer agent may be used. The chain transfer agent used may be a common one. Examples thereof include hydrocarbons such as n-hexane and cyclohexane; aromatic compounds such as toluene and xylene; ketones such as acetone; acetates such as ethyl acetate and butyl acetate; alcohols such as methanol and ethanol; and mercaptans such as methylmercaptan. The chain transfer agent may be used in an amount that varies in accordance with the chain transfer constant of a compound used. The amount thereof usually falls within the range of 0.01-20 wt.% relative to a polymerization solvent.

The polymerization solvent used may be a liquid solvent conventionally used in accordance with the polymerization technique used. To provide a molded article having excellent heat resistance, the VdF/TFE copolymer used in the invention is preferably formed by suspension polymerization (dispersion polymerization) in the presence of a fluorine-based solvent.

The VdF/TFE copolymer contained in the molded article of the invention has a crystal size of $\leq 100$ nm. To provide a molded article having excellent mechanical strength, heat resistance, surface roughness, and ferroelectricity, the crystal size is preferably $\leq 90$ nm, more preferably $\leq 80$ nm, still more preferably $\leq 70$ nm.

The lower limit of the crystal size may be, but is not limited to, 3 nm. To achieve more improved heat resistance, the crystal size is preferably $\geq 5$ nm, more preferably $\geq 8$ nm, still more preferably $\geq 10$ nm.

The crystal size can be determined by a known small-angle X-ray scattering technique (hereinafter, referred to as "SAXS").

Owing to high crystallinity, the primary peak of a scattering vector (q)-small-angle X-ray scattering intensity ($I_x$)

curve in SAXS corresponds to the shortest distance between microcrystals (= crystal size d) in cases where microcrystals having an average size d are randomly packed (reference: A. Guinier, "Ekkusu-sen Kessho-gaku no Riron to Jissai (Theory and Practice of X-ray crystallography)", Rigaku Corp., p513, 1967). Thus, the crystal size d is calculated by the following Bragg equation.

$$\text{Bragg equation: } d = 2\pi \div q$$

The crystals of the VdF/TFE copolymer are β crystals.

To achieve better mechanical strength, heat resistance, and ferroelectricity, the present molded article preferably contains a VdF/TFE copolymer having high crystallinity.

The crystals of the VdF/TFE copolymer constitute nano-oriented crystals (NOCs). NOCs each have a crystal size of $\leq 100$ nm and include crystals (also referred to as nano crystals, NCs) of the VdF/TFE copolymer in which the polymer chain is oriented in the elongational direction (machine direction, MD).

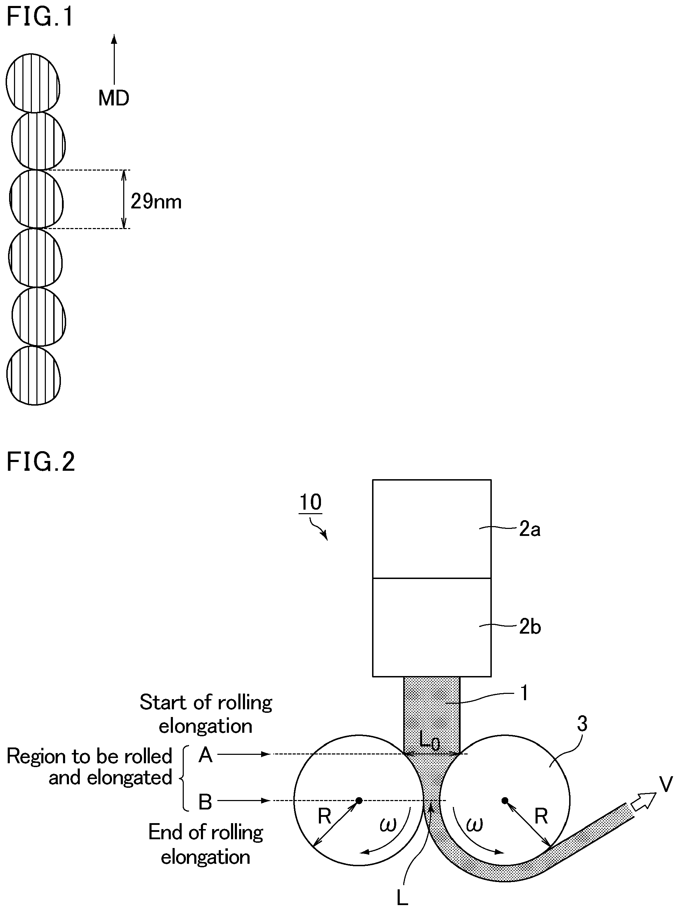

The structure of the NOCs is analyzed using a polarization microscope and the results of X-ray diffraction. The analysis demonstrates that the NOCs have a structure in which spherical nano crystals (NCs) are linked in the form of a rosary along the elongational direction (MD) as illustrated in Fig. 1.

To achieve better mechanical strength, heat resistance, and ferroelectricity, the molded article of the invention contains $\geq 60\%$, preferably $\geq 70\%$, more preferably $\geq 80\%$, still more preferably $\geq 90\%$, particularly preferably $\geq 95\%$, of NOCs of a VdF/TFE copolymer.

The proportion of the NOCs (NOC fraction) contained in the molded article can be calculated by X-ray diffraction.

NOCs are highly oriented and non-NOCs are isotropic. Thus, the NOC fraction can be calculated from the intensity ratio in wide-angle X-ray scattering.

Whether the polymer chain of NCs included in the NOCs constituting the molded article or the NCs themselves constituting the NOCs is/are oriented can be observed using a polarization microscope or by a known X-ray diffraction technique (small-angle X-ray scattering (SAXS), wide-angle X-ray scattering (WAXS)). High crystallinity of the molded article can be concluded by the fact that amorphous halo is hardly observed by WAXS. The examples to be described later can be referred to as appropriate for specific methods of the observation using a polarization microscope and the X-ray diffraction techniques (small-angle X-ray scattering, wide-angle X-ray scattering).

The NCs included in the NOCs and the polymer chains included in the NCs are oriented substantially in MD of the molded article (e.g., sheet).

The crystal size of each NC constituting the NOCs can be determined by measuring the size in MD. For example, the crystal size of a NOC illustrated in Fig. 1 can be determined as about 29 nm.

The present molded article has an arithmetic average roughness of $\leq 3.0$ um. The arithmetic average roughness is more preferably $\leq 2.0$ um, still more preferably $\leq 1.5$ um, particularly preferably $\leq 1.0$ um. Use of a rolling elongation crystallization device to be described later can lead to production of a molded article containing NOCs of a VdF/TFE copolymer as a main component and improvement in the arithmetic average roughness of the surface.

The arithmetic average roughness is a value determined using a portable surface roughness tester in conformity with ISO 1997.

The present molded article preferably has a melting point of $\geq 130°C$, more preferably $1\geq 34°C$, still more preferably $\geq 137°C$.

The melting point of the molded article is the temperature corresponding to the maximum value on a heat-of-fusion curve drawn by increasing the temperature at a rate of 5 K/min using a differential scanning calorimeter (DSC). Alternatively, the melting point of the molded article is the temperature corresponding to the maximum value on a retardation change in the melting behavior during a temperature increase at a rate of 1 K/min using a polarization microscope equipped with a hot stage.

The melting point of the molded article of the invention is preferably higher than the temperature that is 14°C, preferably 10°C, more preferably 7°C, lower than the equilibrium melting point of β crystals of the VdF/TFE copolymer at rest.

The equilibrium melting point ($T_m^0$) means the melting point of a macroscopic perfect crystal that is formed with the molecule chain of a polymer (hereinafter, also referred to as "polymer chain" as appropriate) being fully stretched, and is calculated by the following formula:

$$T_m^0 = \Delta H_u \div \Delta S_u$$

wherein $\Delta H_u$ is the enthalpy of fusion and $\Delta S_u$ is the entropy of fusion.

Specifically, the equilibrium melting point can be determined by the method of Hikosaka et al. using a polarization microscope (M. Hikosaka et al. J. Macromol. Sci. Phys., B31(1), 87 (1992)). For example, the equilibrium melting point of hexagonal crystal of a VdF/TFE copolymer at VdF/TFE = 80/20 (mole ratio) at rest is determined as about 134.3°C (T. Fukushima et al., Polymer Preprints, Japan, 66(1), 2C03 (2017)), and the equilibrium melting point of β crystals at rest is determined as 143.9°C in our study (unpublished).

The melting point is contrasted to the equilibrium melting point of a VdF/TFE copolymer having the same monomer compositional ratio.

The molded article of the invention preferably has a heatproof temperature of ≥ 90°C, more preferably ≥ 110°C, still more preferably ≥ 130°C.

The heatproof temperature of the molded article of the invention is preferably higher than the temperature that is 54°C, more preferably 34°C, still more preferably 14°C, lower than the equilibrium melting point of β crystals of the VdF/TFE copolymer at rest.

The "heatproof temperature" herein means the heatproof temperature measured by test-piece size direct reading using an optical microscope. The "test-piece size direct reading" is performed using an optical microscope equipped with a CCD camera (BX51, available from Olympus Corp.), a hot stage (LK-600PM, available from Linkam Scientific Instruments Ltd.), and image analysis software (Image-Pro PLUS, available from Media Cybernetics, Ltd.) that can quantify the size on a display. The test piece used had a size of 0.7 mm in length and 0.5 mm in width. The test piece was heated at a temperature-increasing rate of 1 K/min. The temperature at which the test piece started to deform (shrink or expand) by 3% or more in the longitudinal direction (MD) or the transverse direction (TD) was defined as the heatproof temperature.

The present molded article preferably has a tensile strength at break of ≥ 80 MPa. The tensile strength at break is more preferably ≥ 110 MPa, still more preferably ≥ 150 MPa. The tensile strength at break is determined using a test piece having a length of 42 mm, a width of 2 mm, and a thickness of 0.01-0.3 mm in conformity with JIS K 7127. The tensile rate is 0.3 mm/s.

The molded article of the invention preferably has an elastic modulus of ≥ 1.0 GPa. The elastic modulus is more preferably ≥ 1.2 GPa, still more preferably ≥ 1.5 GPa, particularly preferably ≥ 2 GPa. The elastic modulus is a value determined by the method in conformity with JIS-7127.

The present molded article is preferably a ferroelectric, and preferably has a remanent polarization of ≥ 45 $mC/m^2$, more preferably ≥ 55 $mC/m^2$. The upper limit thereof may be, but is not limited to, 100 $mC/m^2$, for example.

The remanent polarization is a value determined as follows. Specifically, a sample film having a size of 20 mm × 20 mm is cut out and a pattern of an aluminum electrode (planar electrode) is vacuum deposited on a 5 mm × 5 mm central portion of the film. An electrode provided with two lead lines (30 mm × 80 mm) and formed of aluminum foil reinforced with insulating tape is stuck to the planar electrode using a conductive double-sided tape. This sample film, a function generator, a high voltage amplifier, and an oscilloscope are incorporated into a sawyer-tower circuit. Triangle waves are applied to the sample film (max: ±10 kV) and the response of the sample film is measured using the oscilloscope. Thereby, the remanent polarization is determined.

The present molded article preferably has a coercive field of ≤ 35 MV/m, more preferably ≤ 34 MV/m, yet more preferably ≤ 33 MV/m.

The lower limit of the coercive field may be 5 MV/m, for example.

The coercive field is a value determined as follows. Specifically, a sample film having a size of 20 mm × 20 mm is cut out and a pattern of an aluminum electrode (planar electrode) is vacuum deposited on a 5 mm × 5 mm central portion of the film. An electrode provided with two lead lines (30 mm × 80 mm) and formed of aluminum foil reinforced with insulating tape is stuck to the planar electrode using a conductive double-sided tape. This sample film, a function generator, a high voltage amplifier, and an oscilloscope are incorporated into a sawyer-tower circuit. Triangle waves are applied to the sample film (max: ±10 kV) and the response of the sample film is measured using the oscilloscope. Thereby, the coercive field is determined.

The present molded article may consist only of a VdF/TFE copolymer or may contain a component other than the VdF/TFE copolymer to the extent that the effects of the invention are not impaired.

The present molded article may be, for example, a sheet, a tube or a fiber. Preferred is a sheet because it can be relatively easily produced.

The sheet may have any thickness that can be adjusted as appropriate by the amount of the material to be extruded, for example, in accordance with the intended use. Specifically, the thickness may preferably fall within the range of 80 um to 10 mm, more preferably 90 um to 5 mm, particularly preferably 110 um to 1 mm.

The thickness of the sheet can be measured using a micrometer.

The present molded article having the aforementioned structure has excellent mechanical strength, heat resistance, and ferroelectricity, and also has excellent dimension stability, electric properties, and gas barrier properties, and thus can be used for a variety of applications. For example, its excellent electric properties may be utilized so that the molded article of the invention can be suitably used as a piezoelectric film, a film of an electrowetting device, or a film of a film capacitor. The present molded article can also suitably be used as a pyroelectric film, for example.

(Method for producing the present molded article)

The present molded article may be produced by the following production method, for example. The following production method is a method of crystallization (solidification) by rolling and elongating a VdF/TFE copolymer in the form of a melt and is completely different from a stretching method of rolling and elongating a solidified molded article.

Fig. 2 is a schematic view of a device (rolling elongation crystallization device 10) for producing the molded article of the invention. The rolling elongation crystallization device 10 includes a supercooled melt feeder (including an extruder 2a that melts a VdF/TFE copolymer and feeds a melt of the VdF/TFE copolymer and a cooling adaptor 2b that cools the melt fed from the extruder 2a into a supercooled state) and sandwiching rollers 3. The extruder 2a of the supercooled melt feeder is provided with a slit die (not illustrated) at an outlet thereof, and the slit die has a quadrangular end. The VdF/TFE copolymer melt discharged through the slit die is cooled to a supercooled state while passing through the cooling adaptor 2b (the melt in the supercooled state is referred to as a "supercooled melt"), and the supercooled melt is discharged toward the sandwiching rollers 3. Let the difference between the equilibrium melting point and the crystallization temperature of a hexagonal crystal at rest be the "supercooling degree $\Delta T$". A particularly optimal supercooling degree $\Delta T$ is not limited because it greatly varies in accordance with the type and characterization of the polymer. Still, the supercooling degree $\Delta T$ is preferably -35°C to +35°C, more preferably -30°C to +30°C, still more preferably -20°C to +20°C. The crystallization temperature herein means the temperature of a supercooled melt.

The sandwiching rollers 3 are provided such that paired rotatable rollers face each other, and are configured to sandwich the supercooled melt 1 fed from the supercooled melt feeder and elongate the supercooled melt 1 in the rotating direction of the rollers to mold the supercooled melt 1 into a sheet shape.

In production of the present molded article, the supercooled melt 1 is fed from the supercooled melt feeder, sandwiched between the sandwiching rollers 3, and then rolled and elongated at an elongational strain rate not lower than the critical elongational strain rate, so that the supercooled melt 1 is crystallized. Thereby, the supercooled melt 1 becomes an oriented melt and can be crystallized with this state maintained. The molecular chains contained in the oriented melt associate with each other to cause nucleation (referred to as "homogeneous nucleation") and growth without the help of a foreign substance. This consequently allows for generation of NOCs, resulting in production of the molded article of the invention.

The method for producing the present molded article is further described with reference to the rolling elongation crystallization device 10 of Fig. 2. In Fig. 2, focus is given to a region (hereinafter, referred to as "region AB") from the start (A) of rolling elongation to the end (B) of rolling elongation using the sandwiching rollers 3. The radius of each sandwiching roller 3 of the rolling elongation crystallization device 10 is expressed as R; the angular velocity of each sandwiching roller 3 as $\omega$; the angle at which each sandwiching roller 3 rotates as $\theta$; the thickness of a supercooled melt at any position in the region AB as $L_0$; the thickness of a VdF/TFE copolymer sheet at the point B at the end of the rolling elongation as L; the sheet-taking speed by the sandwiching rollers as V; and the elongational strain rate as $\varepsilon$. The roller rotation angle $\theta$ in the region AB is very small.

$$\theta \ll 1 (\mathrm{rad}) \quad (1)$$

The radius R of each roller is much larger than the sheet thicknesses $L_0$ and L.

$$R \gg L_0, \ L \quad (2)$$

The minute volume $\Phi$ at any position in the region AB is considered with the center of the minute volume taken as the origin. The direction (MD) in which the supercooled melt and the VdF/TFE copolymer sheet travel is taken as an x-axis, the direction (TD) of the width of the supercooled melt sheet is taken as a y-axis, and the direction of the thickness of the supercooled melt sheet is taken as a z-axis. The minute volume $\Phi$ is approximated by a rectangular parallelepiped, and the lengths of the sides of the rectangular parallelepiped are taken as x, y, and $L_0$.

In sheet formation, the width, i.e., y, of the supercooled melt sheet can be considered as sufficiently greater than x and $L_0$ and not being changed by rolling elongation.

$$y = \mathrm{const} \gg x, \ L_0 \quad (3)$$

Thus, in the rolling elongation using the sandwiching rollers, the supercooled melt sheet is compressed in the z-axis direction and is elongated in the x-axis direction. In other words, the rolling elongation using the sandwiching rollers acts only on the x-axis and the z-axis.

Letting the elongational strain rate tensor in the x-axis direction be $\varepsilon_{xx}$ and the elongational strain rate tensor in the z-axis direction be $\varepsilon_{zz}$, the relationship therebetween is defined as follows.

$$\varepsilon_{xx} = -\varepsilon_{zz} \quad (5)$$

In derivation of the formula (5), the following law of conservation of mass related to the minute volume $\Phi$ in the rolling elongation is used.

$$\Phi \approx xyL_0 = const \quad (4)$$

The strain rate $\varepsilon_{zz}$ in the z-axis direction of the region AB in Fig. 2 is defined by the following definitional equation:

$$\varepsilon_{zz} \equiv (1/L_0) \times (dL_0/dt) \quad (6)$$

wherein t represents the time.
In the formula,

$$L_0 = 2R(1 - \cos\theta) + L \quad (7)$$

is satisfied. Thus, based on the formulae (6), (7), and (1), the following formula is approximately obtained.

$$\varepsilon_{zz} \approx -2\omega\sqrt{\{(R/L_0) \times (1 - L/L_0)\}} \quad (8)$$

Based on the formulae (5) and (8), the elongational strain rate to be calculated is obtained.

$$\varepsilon_{xx} \approx 2\omega\sqrt{\{(R/L_0) \times (1 - L/L_0)\}} \quad (9)$$

$\varepsilon_{xx}$ is a function of $L_0$ from the formula (9).
$\varepsilon_{xx}$ has a maximum value at

$$L_0 = 2L \quad (10).$$

This means that $\varepsilon_{xx}$ reaches its maximum at $L_0 = 2L$ and that the maximum elongational strain rate is applied to the supercooled melt.
Letting the maximum elongational strain rate be $\varepsilon_{max}$, substitution of the formula (10) into the formula (9) gives the following formula.

$$\varepsilon_{max} \approx \omega\sqrt{(R/L)} \quad (11)$$

A condition for forming the sheet at a supercritical elongational strain rate is that $\varepsilon_{max}$ is not lower than the critical elongational strain rate $\varepsilon^*$.
Thus, the formula (11) is defined as the elongational strain rate $\varepsilon$, giving the following formula.

[Math. 1]

$$\varepsilon(R,L,\omega) = \omega\sqrt{\frac{R}{L}} \quad \cdots(12)$$

$$V = R\omega \quad (13)$$

$$\omega(R, V) = V/R \quad (14)$$

Based on the formulae (12) and (14), the following formula is given.
[Math. 2]

$$\varepsilon(R,L,V) = \frac{V}{R}\sqrt{\frac{R}{L}} = \frac{V}{\sqrt{RL}} \quad \cdots(15)$$

Accordingly, a desired molded article of the invention can be produced by setting the radius R of each sandwiching roller, the average thickness L of the elongated polymer sheet, and the sheet-taking speed V by the sandwiching rollers such that the elongational strain rate $\varepsilon$(R, L, V) is not lower than the critical elongational strain rate using the formula (15).

The critical elongational strain rate $\varepsilon$*(R, L, V) may be any rate determined by any method. For example, the rate may be calculated by the following approximate expression (Formula i).

(Formula i)

[Math. 3]

$$\varepsilon^*(R,L,V) = \frac{V^*}{\sqrt{RL}}$$

The sheet-taking speed V* at the critical point means the sheet-taking speed V at the critical point at which NOCs are generated upon crystallization of a supercooled VdF/TFE copolymer melt into a VdF/TFE copolymer sheet having a thickness L by feeding the VdF/TFE copolymer melt, sandwiching the VdF/TFE copolymer melt between paired sandwiching rollers each having a radius R, and rolling and elongating the VdF/TFE copolymer melt at the sheet-taking speed V.

In the method for producing the present molded article, the critical elongational strain rate $\varepsilon$*(R, L, V) may be calculated using the following approximate expression (Formula ii).

(Formula ii)

[Math. 4]

$$\varepsilon^*(R,L,V) = \frac{V}{\sqrt{RL^*}}$$

The thickness L* of a VdF/TFE copolymer sheet at the critical point means the thickness L of a VdF/TFE copolymer sheet at the critical point at which NOCs are generated upon crystallization of a supercooled VdF/TFE copolymer melt into a VdF/TFE copolymer sheet having a thickness L by feeding the VdF/TFE copolymer melt, sandwiching the VdF/TFE copolymer melt between paired sandwiching rollers each having a radius R, and rolling and elongating the VdF/TFE copolymer melt at the sheet-taking speed V.

Whether NOCs are generated or not can be determined by, although not limited to, an X-ray diffraction technique described in the examples below.

A VdF/TFE copolymer melt having a high fluidity may be difficult to elongate using sandwiching rollers in rolling elongation and crystallization with rollers, and may not be elongated at the critical elongational strain rate or higher. Thus, in production of the molded article of the invention (VdF/TFE copolymer sheet), the fluidity (melt flow rate, MFR) is preferably adjusted such that the elongation can be performed at the critical elongational strain rate or higher. In other words, the method for producing the present molded article (VdF/TFE copolymer sheet) preferably includes adjusting the fluidity of the VdF/TFE copolymer melt.

In the method for producing the present molded article, the fluidity of the VdF/TFE copolymer melt is adjusted to a fluidity that enables elongation at the critical elongational strain rate or higher. For example, the MFR of the VdF/TFE copolymer melt at 230°C is preferably $\leq 100$ (g/10 min), more preferably $\leq 80$ (g/10 min), still more preferably $\leq 60$ (g/10 min), most preferably $\leq 50$ (g/10 min).

The lower limit of the MFR of the VdF/TFE copolymer melt at 230°C may be any value that enables elongation at the critical elongational strain rate or higher and is usually preferably $\geq 3$ g/10 min.

EXAMPLES

The invention will be described hereinbelow with reference to examples.

The following VdF/TFE copolymer was used in the examples.

VdF/TFE copolymer 1: VdF/TFE = 80/20 (mole ratio), MFR = 16 (g/10 min, measurement temperature: 230°C, load: 2.1 kgf), weight average molecular weight = $19 \times 10^4$

The following VdF/TFE copolymer was used in the comparative examples.

VdF/TFE copolymer 2: VdF/TFE = 80/20 (mole ratio), MFR = 6 (g/10 min, measurement temperature: 230°C, load: 2.1 kgf), weight average molecular weight = $23 \times 10^4$

The evaluations in the examples and the comparative examples were performed by the following methods.

(1) Observation with polarization microscope

The samples obtained in the examples and the comparative examples were observed using a polarization microscope. The polarization microscope used was BX51 available from Olympus Corp. and the observation was performed in crossed nicols. To quantitatively measure the change in retardation, a sensitive color test plate was inserted between a polarizer and an analyzer (polarizing plate) of the polarization microscope (Reference: Kobunshi Sozai no Henko Kenbikyo Nyumon (Introduction to polarization microscope for polymer material), Yu Awaya, AGNE Gijutsu Center Inc., 2001, p.75-103). The observation with the polarization microscope was performed at room temperature, 25°C. Each sample was observed in the sheet thickness direction (ND, through direction).

(2) X-Ray Diffraction (small-angle X-ray scattering)

The samples were observed by SAXS. SAXS was performed in conformity with "Kobunshi Ekkusu-sen Kaisetsu (Polymer X-ray diffraction)", Masao Kakudo, Nobutami Kasai, Maruzen Publishing Co., Ltd., 1968, and "Kobunshi Ekkusu-sen Kaisetsu (Polymer X-ray diffraction)", edition 3.3, Toru Masuko, Yamagata University Co-op, 1995. More specifically, SAXS was performed with Beamline BL40B2 at Japan Synchrotron Radiation Research Institute (JASRI), SPring-8, at an X-ray wavelength λ of 0.15 nm, a camera length of 3 m, and room temperature, 25°C, using an imaging plate as a detector. The observation was performed in three directions, i.e., the direction (through) perpendicular to MD and TD, the direction (edge) parallel to TD, and the direction (end) parallel to MD. For the observation of the samples in the through and edge directions, MD was set to be the Z-axis direction. For the observation of the samples in the end direction, TD was set to be the Z-axis direction. The time period during which the samples were exposed to X-rays was 5-180 seconds. The imaging plate was scanned with a scanning device available from Rigaku Corp. and reading software (available from Rigaku Corp., raxwish, control), and thereby a two-dimensional image was obtained.

(3) X-Ray Diffraction (wide-angle X-ray scattering)

The samples were observed by WAXS. WAXS was performed with Beamline BL03XU or BL40B2 at Japan Synchrotron Radiation Research Institute (JASRI), SPring-8, at an X-ray wavelength λ of 0.0709 nm, a camera length (R) of 280 mm, and room temperature, 25°C, using an imaging plate as a detector. For the observation of the samples in the through and edge directions, MD was set to be the Z-axis direction. For the observation of the samples in the end direction, TD was set to be the Z-axis direction. The time period during which the samples were exposed to X-rays was 10-180 seconds. The imaging plate was scanned with a scanning device available from Rigaku Corp. and reading software (available from Rigaku Corp., raxwish, control), and thereby a two-dimensional image was obtained.

(4) Crystal size and structure of NOCs

The crystal size (d) of the VdF/TFE copolymer was determined from the two-point image in MD of the small-angle X-ray scattering image. The primary peak of a scattering vector (q)-small-angle X-ray scattering intensity (Ix) curve in SAXS corresponds to the shortest distance between microcrystals (= crystal size d) in cases where microcrystals having an average size d are randomly packed (reference: A. Guinier, "Ekkusu-sen Kessho-gaku no Riron to Jissai (Theory and Practice of X-ray crystallography)", Rigaku Corp., p513, 1967). Thus, the crystal size d is calculated by the Bragg equation.

$$\text{Bragg equation: } d = 2\pi \div q$$

(5) Heatproof temperature, melting point

The heatproof temperatures of the samples of the examples and the comparative examples were measured by test-piece size direct reading using an optical microscope. Specifically, each test piece (0.6 mm in length, 0.8 mm in width) was placed in a hot stage (L-600A, available from Linkam Scientific Instruments, Ltd.) and the temperature in the hot stage was increased at a temperature-increasing rate of 1 K/min. At this time, an optical microscope equipped with a CCD camera (BX51, available from Olympus Corp.) was used for observation and recording. Using image analysis software (Image-Pro PLUS, available from Media Cybernetics, Ltd.), the length direction (MD) and the width direction (TD) of the test piece were quantitatively measured. The temperature at which the test piece started to shrink (or expand) by $\geq 3\%$ in MD or TD was defined as the heatproof temperature $T_H$. The melting points of the samples were also analyzed. The melting point was determined as the temperature corresponding to the maximum value of the retardation change in the melting behavior during the temperature increase at a rate of 1 K/min using a polarization microscope equipped with a hot stage.

(6) Melting point

The melting point of the molded article was determined as the temperature corresponding to the maximum value on a heat-of-fusion curve drawn by increasing the temperature at a rate of 5 K/min using a differential scanning calorimeter (DSC).

(7) Tensile stress at break

The tensile stress at break was determined in conformity with JIS-7127.

(8) Tensile modulus

The tensile modulus was a value determined by the method in conformity with JIS-7127.

(9) Surface roughness

The arithmetic average roughness (Rz) was measured using a portable surface roughness tester (SJ-210, available from Mitsutoyo Corp.) in conformity with ISO 1997.

(10) Remanent polarization and coercive field

A sample film having a size of 20 mm $\times$ 20 mm was cut out and a pattern of an aluminum electrode (planar electrode) was vacuum deposited on a 5 mm $\times$ 5 mm central portion of the film. An electrode provided with two lead lines (30 mm $\times$ 80 mm) and formed of aluminum foil reinforced with insulating tape was stuck to the planar electrode using a conductive double-sided tape. This sample film, a function generator, a high voltage amplifier, and an oscilloscope were incorporated into a sawyer-tower circuit. Triangle waves were applied to the sample film (max: $\pm 10$ kV) and the response of the sample film was measured using the oscilloscope. Thereby, the remanent polarization and the coercive field were determined.

Examples 1-20

Using the rolling elongation crystallization device schematically illustrated in Fig. 2, the VdF/TFE copolymer was elongated and crystallized. The conditions for elongation and crystallization are as shown in Table 1.

[Table 1]

| | Maximum extrusion temperature ($T_{max}$)/ °C | Melt temperature ($T_{melt}$)/°C | Roller temperature ($T_R$)/°C | Elongation strain rate ($\varepsilon$) /s$^{-1}$ | Sample thickness /mm | Crystal size (d) /nm |
|---|---|---|---|---|---|---|
| Example 1 | 210 | 130 | 120 | 10 | 0.19 | 28 |
| Example 2 | 210 | 130 | 120 | 31 | 0.15 | 38 |
| Example 3 | 210 | 136 | 120 | 21 | 0.18 | 38 |
| Example 4 | 200 | 136 | 120 | 35 | 0.18 | 55 |
| Example 5 | 200 | 136 | 120 | 45 | 0.16 | 57 |
| Example 6 | 210 | 139 | 120 | 29 | 0.17 | 51 |
| Example 7 | 210 | 139 | 120 | 37 | 0.16 | 54 |
| Example 8 | 220 | 144 | 120 | 38 | 0.15 | 57 |
| Example 9 | 180 | 147 | 120 | 27 | 0.20 | 56 |
| Example 10 | 210 | 148 | 90 | 59 | 0.11 | 30 |
| Example 11 | 200 | 136 | 85, 90 | 13 | 0.21 | 29 |
| Example 12 | 200 | 145 | 80, 85 | 40 | 0.14 | 27 |
| Example 13 | 200 | 149 | 75, 80 | 57 | 0.12 | 24 |
| Example 14 | 200 | 137 | 90 | 17 | 0.20 | 29 |
| Example 15 | 200 | 140 | 110 | 40 | 0.11 | 29 |
| Example 16 | 200 | 146 | 105 | 67 | 0.097 | 28 |
| Example 17 | 200 | 146 | 105 | 75 | 0.088 | - |
| Example 18 | 210 | 158 | 90 | 85 | 0.12 | 30 |
| Example 19 | 210 | 152 | 90 | 28 | 0.18 | 28 |

(continued)

|  | Maximum extrusion temperature ($T_{max}$)/ °C | Melt temperature ($T_{melt}$)/°C | Roller temperature ($T_R$)/°C | Elongation strain rate ($\varepsilon$) /s$^{-1}$ | Sample thickness /mm | Crystal size (d) /nm |
|---|---|---|---|---|---|---|
| Example 20 | 210 | 158 | 90 | 110 | 0.11 | 35 |

The "Maximum extrusion temperature ($T_{max}$)/°C" in Table 1 represents the temperature of an extruder when the VdF/TFE copolymer was melted using a heater of the extruder to prepare the VdF/TFE copolymer melt.

The "Melt temperature ($T_{melt}$)/°C" in Table 1 represents the temperature of the VdF/TFE copolymer melt when the VdF/TFE copolymer melt was rolled and elongated using rollers.

The "Roller temperature ($T_R$)/°C" in Table 1 represents the surface temperature of the rollers when the VdF/TFE copolymer melt was rolled and elongated using the rollers. If two temperatures are shown in Table 1, they represent the respective surface temperatures of the two facing rollers.

The "Elongation strain rate ($\varepsilon$)/s$^{-1}$" in Table 1 represents the elongational strain rate when the VdF/TFE copolymer melt was rolled and elongated using the rollers.

The "sample thickness/mm" in Table 1 represents the thickness of the sample obtained by elongation and crystallization.

The "Crystal size (d)/nm" in Table 1 represents the crystal size of NOCs of the sample obtained by elongation and crystallization.

Comparative Example 1 and Comparative Example 2

An extruder was used to produce a VdF/TFE copolymer sheet. The extrusion molding conditions were as follows. A resin was melted at a temperature of 240°C and extruded into a sheet shape through a die. The sheet was solidified on a cast roller at a temperature of 60°C. Thereby, a sample of Comparative Example 2 was produced. Sample thickness: 0.057 mm

The resulting sheet was stretched using a stretching machine (biaxial film stretcher, available from Imoto machinery Co., Ltd.), whereby a uniaxially stretched sheet was produced. The stretching was performed in MD at an ambient temperature of 60°C with a stretch ratio of five times.

The resulting uniaxially stretched sheet was fixed within a frame and heat-set at an ambient temperature of 113°C for 10 minutes. Thereby, a sample of Comparative Example 1 was produced. Sample thickness: 0.021 um

Observation with polarization microscope

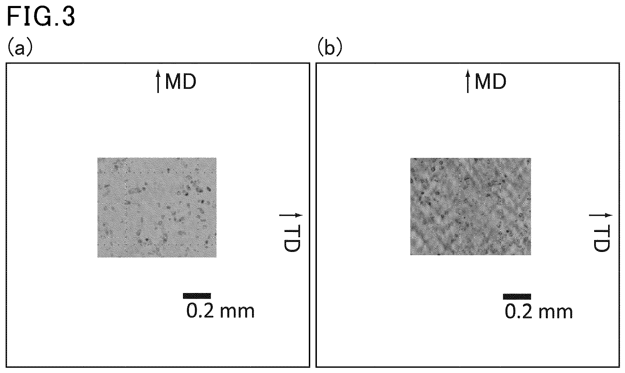

The samples obtained above were observed using a polarization microscope in the sheet thickness direction (ND, through direction). Fig. 3 shows the results of observation using a polarization microscope on Example 11 in Table 1 as a representative example . Fig. 3(a) is a polarization microscopic image of the sample with MD parallel to a sensitive color test plate and Fig. 3(b) is a polarization microscopic image of the sample at the extinction angle.

As the sample was rotated with the sensitive color test plate being inserted, the color in the elongational direction (MD) (i.e., retardation) changed from reddish purple to yellow (Fig. 3(a)), and then to reddish purple, exhibiting a clear extinction angle (reddish purple) (Fig. 3(b)). Thus, this change in retardation demonstrates that the polymer chain of the sample (Example 11 of Table 1) was oriented in the elongational direction (MD).

X-Ray Diffraction (small-angle X-ray scattering)

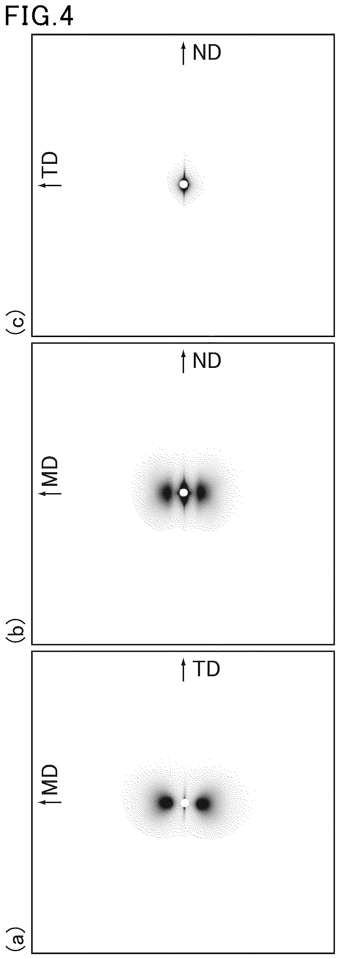

The samples of the examples were observed by SAXS. Fig. 4 shows SAXS images of Example 11 in Table 1 as a representative example . Fig. 4(a) shows the result of observation in the through direction; Fig. 4(b) shows the result of observation in the edge direction; and Fig. 4(c) shows the result of observation in the end direction. Fig. 4(a) and Fig. 4(b) each show a sharp two-point image in MD. This demonstrates that the crystals (NCs) of the VdF/TFE copolymer are oriented in MD. Fig. 4(c) shows only diffuse scattering and no correlation with TD and ND. This means that the crystals are non-oriented in TD and ND, and therefore demonstrates that the sample according to the example of the VdF/TFE copolymer formed NOCs.

X-Ray Diffraction (wide-angle X-ray scattering)

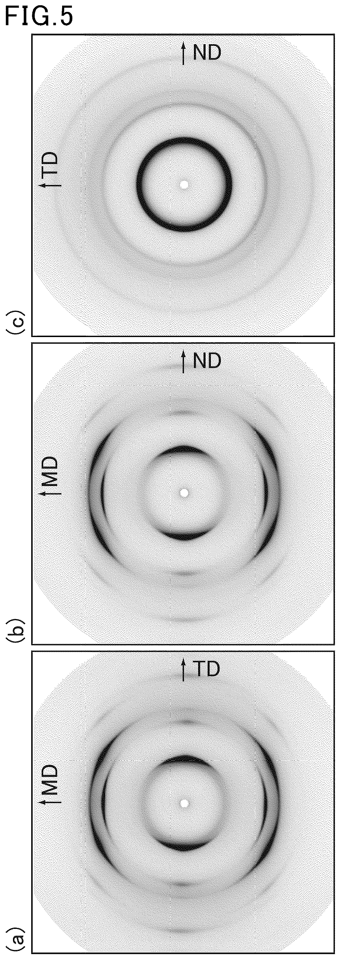

The samples of the examples of the VdF/TFE copolymer were observed by WAXS. Fig. 5 shows WAXS images of Example 11 in Table 1 as a representative example . Fig. 5(a) shows the result of observation in the through direction; Fig. 5(b) shows the result of observation in the edge direction; and
Fig. 5(c) shows the result of observation in the end direction. Fig. 5(a) and Fig. 5(b) each show a fiber pattern, which demonstrates that the polymer chain (c-axis of crystal) was highly oriented in MD. In contrast, Fig. 5(c) shows a Debye-Scherrer ring with substantially no orientation, which demonstrates that the a-axis and b-axis of the crystals of the sample were substantially no oriented. This demonstrates that the sample formed NOCs.
Further, the results of Fig. 5 demonstrate that the crystals of the sample according to the example of the VdF/TFE copolymer were β crystals (A.J. Lovinger et al., Macromolecules 21, 78 (1988)). Since amorphous halo was hardly observed, the sample was found to have high crystallinity.

Analysis of crystal size and structure of NOC

The crystal size (d) of the sample according to the example of the VdF/TFE copolymer was determined from the two-point image in MD of Fig. 4. The crystal size (d) of the sample of Example 11 in Table 1 as a representative example was found to be 29 nm. For Examples 1-16 and 18-20, the crystal sizes are shown in Table 1.
The results of microscopic observation and X-ray observation lead to a presumption that the sample according to the example of the VdF/TFE copolymer has a structure in which substantially spherical NCs as illustrated in Fig. 1 are arranged in a paracrystalline manner in MD.

Analysis of heatproof temperature and melting point

The heatproof temperatures of the samples of Example 20 in Table 1 and Comparative Example 1 were measured by test-piece size direct reading using an optical microscope. The length direction (MD) and the transverse direction (TD) of the test piece were quantitatively measured. The temperature at which the test piece started to shrink (or expand) by $\geq 3\%$ in MD or TD was defined as the heatproof temperature Th. The melting point Tm was also analyzed.

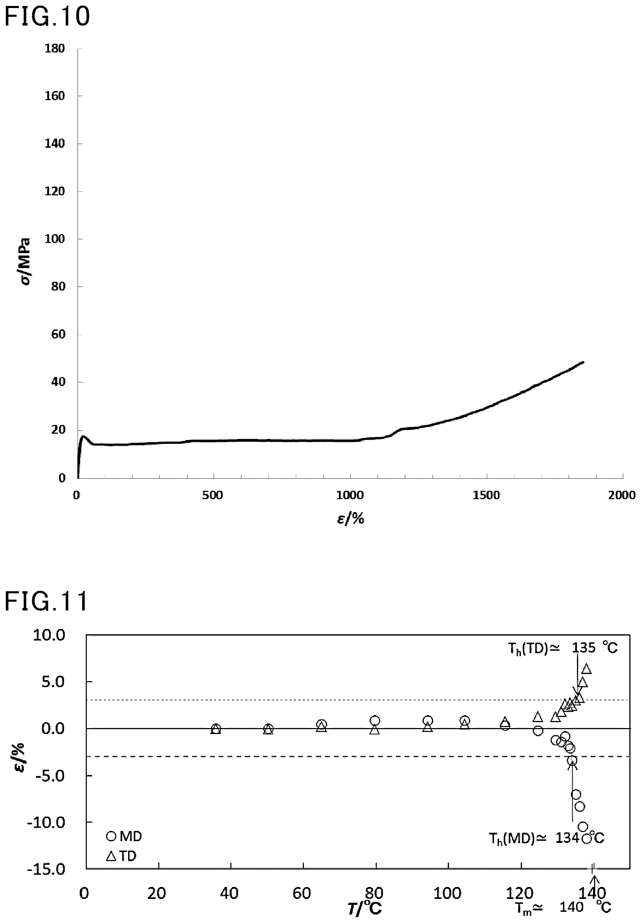

Fig. 11 shows that the heatproof temperature Th at which the sample of Example 20 deformed by $\geq 3\%$ e was about 134°C. The melting point Tm was about 140°C.

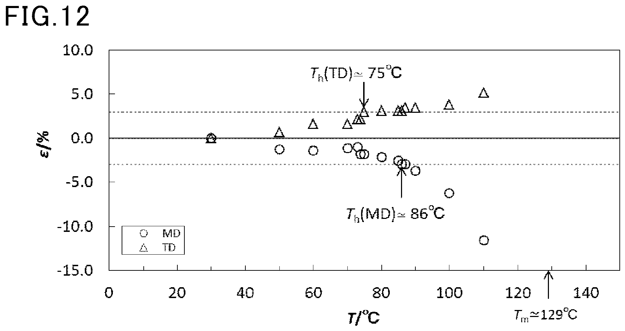

Fig. 12 shows that the heatproof temperature Th of the sample of Comparative Example 1 was about 75°C. The melting point Tm was about 129°C.

Melting point

The melting points of the samples of Examples 9, 10, and 16 in Table 1 and of Comparative Example 1 were each determined as the temperature corresponding to the maximum value on a heat-of-fusion curve drawn by increasing the temperature at a rate of 5 K/min using a differential scanning calorimeter (DSC). The melting point Tm of the sample of Example 9 was 137.2°C, that of the sample of Example 10 was 138.1°C, and that of the sample of Example 16 was 137.7°C. The melting point Tm of the sample of Comparative Example 1 had two maximum values, 126.4°C and 128.0°C.
Analysis with the optical microscope and DSC demonstrates that in comparison between Example 11 and Comparative Example 1, the heatproof temperature and the melting point of the sample of the example were greatly higher than those of the sample of the comparative example.

Tensile stress at break, tensile modulus

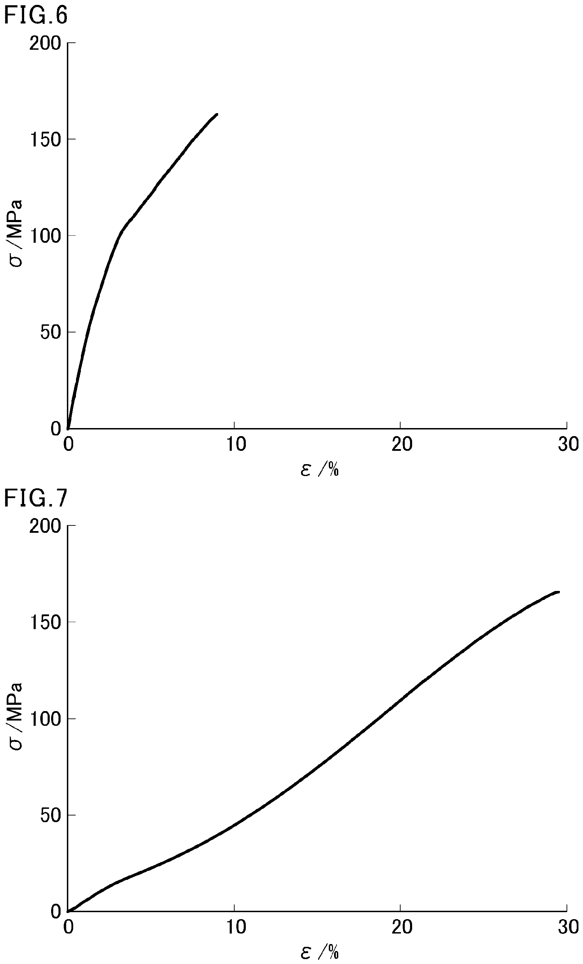

For the Examples 10-16 and 18-20 in Table 1 and Comparative Examples 1 and 2, the tensile stress at break and the tensile modulus were determined. The results are shown in Table 2. Fig. 6 is a typical diagram of the results of measuring the tensile stress at break $\sigma_B$ and the tensile modulus $E_t$ of the sample of Example 10. Fig. 7 is a typical diagram of the results of measuring the tensile stress at break ($\sigma_B$) and the tensile modulus ($E_t$) of the sample of Comparative Example 1. Fig. 10 is a typical diagram of the results of measuring the tensile stress at break ($\sigma_B$) and the tensile modulus ($E_t$) of the sample of Comparative Example 2. Comparison between the samples of the examples and the comparative examples demonstrates that the elastic modulus of each of the samples of the examples was greatly higher than that of each of the samples of the comparative examples.

[Table 2]

| | Tensile stress at break ($\sigma_B$)/MPa | Tensile modulus ($E_t$)/GPa |
|---|---|---|
| Example 10 | 156 | 4.3 |
| Example 11 | 84 | 1.3 |
| Example 12 | 105 | 1.4 |
| Example 13 | 117 | 1.1 |
| Example 14 | 131 | 1.0 |
| Example 15 | 91 | 1.5 |
| Example 16 | 116 | 1.8 |
| Example 18 | 140 | 2.3 |
| Example 19 | 181 | 1.7 |
| Example 20 | 143 | 2.2 |
| Comparative Example 1 | 165 | 0.50 |
| Comparative Example 2 | 47 | 0.12 |

Surface roughness

For the Examples 9-11 in Table 1 of the VdF/TFE copolymer, the arithmetic average roughness (Rz) was determined using a portable surface roughness tester (SJ-210, available from Mitsutoyo Corp.) in conformity with ISO 1997. Rz of the sample of Example 9 was 2.54 um, that of the sample of Example 10 was 0.39 um, and that of the sample of Example 11 was 0.19 um. Comparison between the samples of Examples 10 and 11 with the sample of Example 9 demonstrates that the Rz of the samples of Examples 10 and 11 were greatly lower than that of the sample of Example 9. This was achieved by setting the temperatures of the rollers to a lower value than the crystallization temperature in Examples 10 and 11 to enable easy removal of a molded sample from the rollers.

Remanent polarization and coercive field

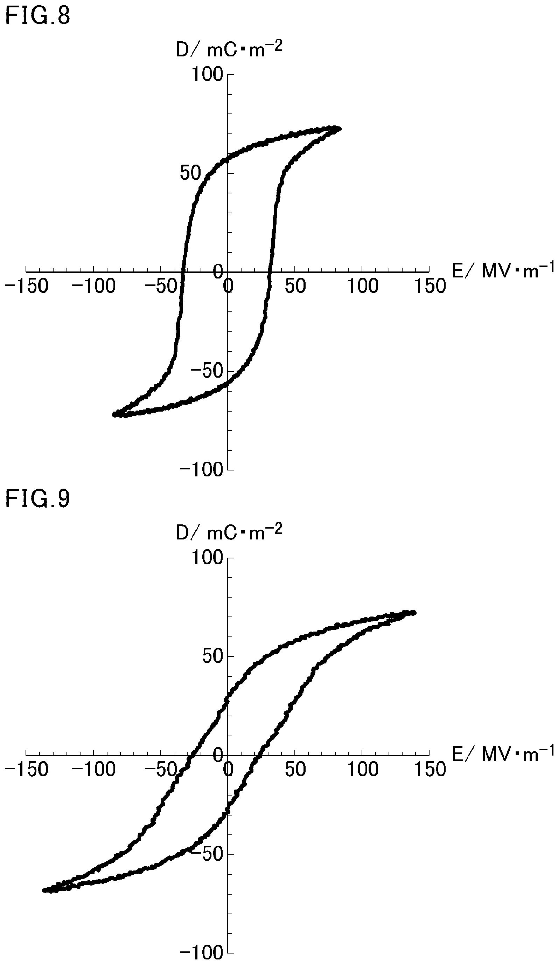

The remanent polarization and coercive field of the samples of Example 10, 16, and 17 in Table 1 and of Comparative Example 1 were determined at an electric field of 85 MVm$^{-1}$ for the sample of Example 10, an electric field of 80 MVm$^{-1}$ for the samples of Examples 16 and 17, and an electric field of 140 MVm$^{-1}$ for the sample of Comparative Example 1. The results are shown in Table 3. Fig. 8 is a typical diagram of the results of measuring the remanent polarization $P_r$ and the coercive field $E_c$ of the sample of Example 10. Fig. 9 is a typical diagram of the results of measuring the remanent polarization $P_r$ and the coercive field $E_c$ of the sample of Comparative Example 1. The samples of Examples 10, 16, and 17 showed a high remanent polarization $P_r$ exceeding 45 mCm$^{-2}$ in comparison with the sample of Comparative Example 1. The samples of Examples 10, 16, and 17 showed a low coercive field $E_c$ lower than 35 MVm$^{-1}$ even though they showed a high remanent polarization.

[Table 3]

| | Remanent polarization ($P_r$)/mCm$^{-2}$ | Coercive field ($E_c$)/MVm$^{-1}$ |
|---|---|---|
| Example 10 | 56.6 | 32.5 |
| Example 16 | 47.6 | 31.5 |
| Example 17 | 50.2 | 30.4 |
| Comparative Example 1 | 27.3 | 25.5 |

INDUSTRIAL APPLICABILITY

The present molded article has excellent heat resistance, mechanical properties, and ferroelectricity in comparison with a molded article formed of a conventional VdF/TFE copolymer, and thus can be used for applications of a molded article containing crystals of a conventional vinylidene fluoride/tetrafluoroethylene copolymer, such as a piezoelectric film and a pyroelectric sensor. In addition, the present molded article can achieve polarization reversal at a low coercive field, and thus can suitably be used for applications such as a high-speed switching device, a vibration power generator, an imaging device, and a wearable sensor.

REFERENCE SIGNS LIST

1: supercooled melt
2a: extruder
2b: cooling adaptor
3: sandwiching roller
10: rolling elongation crystallization device

**Claims**

**1.** A molded article which

(i) has an arithmetic average roughness of $\leq$ 3.0 um, measured using a portable surface roughness tester (SJ-210 of Mitsutoyo Corp.) in conformity with ISO 1997, and
(ii) is made from a vinylidene fluoride (VdF)/tetrafluoroethylene (TFE) copolymer which

- contains $\geq$ 90 mol% of units derived from VdF or TFE, based on all polymerized units of the copolymer,
- contains 50-95 mol% of VdF units and 5-50 mol% of TFE units, based on the total of VdF units and TFE units in the copolymer, and
- comprises, in an amount of $\geq$ 60% based on the VdF/TFE copolymer, crystals of the VdF/TFE copolymer, which are nano-oriented $\beta$ crystals having a size of $\leq$ 100 nm, determined by the method defined in the description.

**2.** The molded article of claim 1, which has a melting point of $\geq$ 130°C, determined as the temperature corresponding to the maximum value on a heat-of-fusion curve drawn by increasing the temperature at a rate of 5 K/min using a differential scanning calorimeter (DSC).

**3.** The molded article of any of claims 1-2, which has a heatproof temperature of $\geq$ 90°C, determined according to the method defined in the description.

**4.** The molded article of any of claims 1-3, which has an elastic modulus of $\geq$ 1.0 GPa, determined by the method according to JIS-7127.

**5.** The molded article of any of claims 1-4, which has a remanent polarization of $\geq$ 45 mC/m$^2$, determined according to the method defined in the description.

**6.** The molded article of any of claims 1-5, which has a coercive field of $\leq$ 35 MV/m, determined according to the method defined in the description.

**Patentansprüche**

**1.** Formkörper, der

(i) eine arithmetische mittlere Rauheit von $\leq$ 3,0 um, gemessen unter Verwendung eines tragbaren Oberflächenrauheitstesters (SJ-210 von Mitsutoyo Corp.) in Übereinstimmung mit ISO 1997, aufweist und
(ii) aus einem Vinylidenfluorid-(VdF)/Tetrafluorethylen-(TFE)-Copolymer hergestellt ist, das

- basierend auf allen polymerisierten Einheiten des Copolymers, $\geq$ 90 Mol-% an Einheiten enthält, die von VdF oder TFE abgeleitet sind, und

- in einer Menge von ≥ 60%, basierend auf dem VdF-/TFE-Copolymer, Kristalle des VdF-/TFE-Copolymers umfasst, die nano-orientierte β-Kristalle mit einer durch die in der Beschreibung definierten Methode bestimmten Größe von ≤ 100 nm sind.

2. Formkörper gemäß Anspruch 1, der einen Schmelzpunkt von ≥ 130°C aufweist, der bestimmt ist als die Temperatur, die dem Maximalwert auf einer Schmelzwärmekurve entspricht, die durch Erhöhen der Temperatur mit einer Rate von 5 K/min unter Verwendung eines dynamischen Differenzkalorimeters (DDK) erstellt wird.

3. Formkörper gemäß einem der Ansprüche 1-2, der eine gemäß der in der Beschreibung definierten Methode bestimmte Wärmebeständigkeitstemperatur von ≥ 90°C aufweist.

4. Formkörper gemäß einem der Ansprüche 1-3, der ein durch die Methode gemäß JIS-7127 bestimmtes Elastizitätsmodul von ≥ 1,0 GPa aufweist.

5. Formkörper gemäß einem der Ansprüche 1-4, der eine gemäß der in der Beschreibung definierten Methode bestimmte remanente Polarisierung von ≥ 45 mC/m$^2$ aufweist.

6. Formkörper gemäß einem der Ansprüche 1-5, der ein gemäß der in der Beschreibung definierten Methode bestimmtes Koerzitivfeld von ≤ 35 MV/m aufweist.

**Revendications**

1. Article moulé qui

    (i) présente une rugosité moyenne arithmétique de ≤ 3,0 μm, mesurée à l'aide d'un testeur de rugosité de surface portatif (SJ-210 de Mitsutoyo Corp.) en conformité avec la norme ISO 1997, et
    (ii) est créé à partir d'un copolymère de fluorure de vinylidène (VdF)/tétrafluoroéthylène (TFE) qui

        - contient ≥ 90 % en mole d'unités dérivées de VdF ou de TFE, sur la base de toutes les unités polymérisées du copolymère,
        - contient de 50 à 95 % en mole d'unités de VdF et de 5 à 50 % en mole d'unités de TFE, sur la base du total d'unités de VdF et d'unités de TFE dans le copolymère, et
        - comprend, en une quantité de ≥ 60 % sur la base du copolymère de VdF/TFE, des cristaux du copolymère de VdF/TFE, qui sont des cristaux β nano-orientés présentant une taille de ≤ 100 nm, déterminée par le procédé défini dans la description.

2. Article moulé selon la revendication 1, qui présente un point de fusion de ≥ 130 °C, déterminé en tant que température correspondant à la valeur maximale d'une courbe de chaleur de fusion dessinée en augmentant la température à une vitesse de 5 K/min à l'aide d'un calorimètre différentiel à balayage (DSC).

3. Article moulé selon l'une quelconque des revendications 1 à 2, qui présente une température de résistance à la chaleur de ≥ 90 °C, déterminée selon le procédé défini dans la description.

4. Article moulé selon l'une quelconque des revendications 1 à 3, qui présente un module élastique de >_ 1,0 GPa, déterminé par le procédé selon la norme JIS-7127.

5. Article moulé selon l'une quelconque des revendications 1 à 4, qui présente une polarisation rémanente de ≥ 45 mC/m$^2$, déterminée selon le procédé défini dans la description.

6. Article moulé selon l'une quelconque des revendications 1 à 5, qui présente un champ coercitif de ≤ 35 MV/m, déterminé selon le procédé défini dans la description.

FIG.1

MD

29nm

FIG.2

10

2a

2b

1

Start of rolling
elongation

Region to be rolled
and elongated

A

B

$L_0$

3

V

R

ω

ω

R

End of rolling
elongation

L

# FIG.3

(a)

(b)

# FIG.4

## FIG.5

FIG.6

FIG.7

FIG.8

FIG.9

## FIG.10

## FIG.11

FIG.12

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 5487964 B
- WO 2016035598 A
- US 2004131862 A
- WO 2014158956 A
- EP 2910604 A

### Non-patent literature cited in the description

- **J.C. HICKS et al.** *J. Appl. Phys.,* 1978, vol. 49, 6092
- **S. TASAKA et al.** *J. Appl. Phys.,* 1985, vol. 57 (3), 906
- **M. HIKOSAKA et al.** *Polymer Preprints, Japan,* 2015, vol. 64 (2), 1G11
- **J.M. CARR et al.** *Polymer,* 2013, vol. 54 (6), 1679-1690
- **A.J. LOVINGER et al.** *Macromolecules,* 1986, vol. 19, 1491
- **M. HIKOSAKA.** *Polymer,* 1987, vol. 28, 1257
- **K. OKADA et al.** *Polymer Preprints, Japan,* 2014, vol. 63 (1), 1331
- **A. GUINIER.** Ekkusu-sen Kessho-gaku no Riron to Jissai (Theory and Practice of X-ray crystallography). Rigaku Corp, 1967, 513
- **M. HIKOSAKA et al.** *J. Macromol. Sci. Phys.,* 1992, vol. B31 (1), 87
- **T. FUKUSHIMA et al.** *Polymer Preprints, Japan,* 2017, vol. 66 (1), 2C03
- **KOBUNSHI SOZAI ; HENKO KENBIKYO NYUMON.** Introduction to polarization microscope for polymer material. AGNE Gijutsu Center Inc, 2001, 75-103
- **MASAO KAKUDO ; NOBUTAMI KASAI.** Kobunshi Ekkusu-sen Kaisetsu (Polymer X-ray diffraction). Maruzen Publishing Co., Ltd, 1968
- Kobunshi Ekkusu-sen Kaisetsu (Polymer X-ray diffraction). Toru Masuko, Yamagata University Co-op, 1995
- **A.J. LOVINGER et al.** *Macromolecules,* 1988, vol. 21, 78